# EUROPÄISCHE PATENTSCHRIFT

(11) **EP 2 501 036 B1**
(45) Veröffentlichungstag und Bekanntmachung des Hinweises auf die Patenterteilung: **30.07.2014**
(21) Anmeldenummer: 12158623.4
(22) Anmeldetag: 08.03.2012
(51) Int. Cl.: H03F 3/08

(54) **Schaltungsanordnung zur Auswertung photoelektrischer Messungen**
Circuit configuration for evaluating photoelectric measurements
Circuit d'évaluation de mesures photoélectriques

(30) Priorität: 17.03.2011 AT 1572011
(43) Veröffentlichungstag der Anmeldung: 19.09.2012
(73) Patentinhaber: DiTest Fahrzeugdiagnose GmbH, 8020 Graz (AT)
(72) Erfinder: Axmann, Harald, 8501 Lieboch (AT); Eichberger, Bernd, 8010 Graz (AT)
(74) Vertreter: Pinter, Rudolf

(56) Entgegenhaltungen:
- WO-A1-00/11780
- DE-A1- 4 206 555
- DE-A1-102005 044 679
- US-A- 5 343 160
- US-A- 5 347 389
- US-A- 5 561 288
- US-A1- 2001 050 333
- US-A1- 2003 218 508
- US-A1- 2005 175 359

## Beschreibung

Die Erfindung betrifft eine Schaltungsanordnung zur Auswertung photoelektrischer Messungen, insbesonders zur Streulichtmessung von Partikeln im Abgas von Brennkraftmaschinen, mit einem basierend auf dem zu messenden Licht einen analogen Photostrom liefernden Detektor, einem eingangsseitig damit verbundenen Transimpedanz-Verstärker, sowie einem mit dem Ausgang des Transimpedanz-Verstärkers verbundenen Analog-/Digitalwandler (ADC) mit differentieller Eingangsstufe, dessen Ausgang ein dem zu messenden Licht proportionales Digitalsignal für eine angeschlossene digitale Auswerteeinheit bereitstellt.

Für photoelektrische Messungen werden als lichtempfindliche Detektoren heutzutage zumeist Photodioden verwendet, die einen Ausgangsstrom proportional zum einfallenden Licht liefern, der an einer geeigneten Schaltungsanordnung ausgewertet wird. Speziell bei geringen absoluten Lichtstärken des einfallenden Lichtes sowie auch bei geringen festzustellenden Änderungen im zeitlichen Verlauf der Lichtstärke sind spezielle Ausgestaltungen dieser Schaltungsanordnungen notwendig, um zu vermeiden, dass Hintergrundrauschen und Umgebungsstörungen aussagekräftige Messungen verhindern.

Insbesonders bei Geräten zur Messung von Partikelkonzentrationen, wie sie beispielsweise auch zur Abgasmessung an Dieselmotoren als Antriebsmaschinen für Fahrzeuge verwendet werden, sind die Anforderungen hinsichtlich einer Erhöhung der Sensitivität zur Vermessung des Abgases auch moderner Brennkraftmaschinen in den letzten Jahren immer mehr gestiegen, was dazu geführt hat, dass Messgeräte auf der Basis der Streulichtmessung entwickelt wurden, die auch extrem niedrige Partikelkonzentrationen noch zuverlässig messen können, wobei aber nur sehr schwaches Streulicht zur Verfügung steht, das die qualitativen Anforderungen an die verwendete Auswertungsschaltung weiter in die Höhe treibt.

Die bisher bekannten und prinzipiell zur Auswertung photoelektrischer Messungen geeigneten Schaltungsanordnungen der eingangs genannten Art verwenden an der Schnittstelle vom analogen in den digitalen Bereich für Präzisionsanwendungen hoch auflösende ADCs mit differentieller Eingangsstufe, welche gegenüber single-ended- und pseudo-differential-Varianten insbesonders im Hinblick auf Störungsunterdrückung und Signalempfindlichkeit bei kleinen Signalstärken große Vorteile bieten. Stets problematisch ist insbesonders bei extrem niedrigen nachzuweisenden bzw. zeitlich hoch aufzulösenden Photoströmen der zur Wandlung des Photostroms zwischen Detektorausgang und Spannungseingang der üblichen ADCs mit differentieller Eingangsstufe erforderliche Transimpedanz-Verstärkerbzw. dessen Beschaltung, die eine rausch- sowie störungsarme Umwandlung des sehr kleinen Photostroms in eine differentielle Spannung bei gleichzeitig sehr hoher Verstärkung und ebenso hoher Gleichtaktunterdrückung ermöglichen soll.

Aufgabe der vorliegenden Erfindung ist es, die zuletzt genannten Anforderungen an die Schaltungsanordnung hinsichtlich insbesonders des Transimpedanz-Verstärkers zu erfüllen und damit eine möglichst störungsarme und genaue Auswertung auch kleinster Photoströme sicherzustellen.

Bisher in derartigen Zusammenhängen verwendete Schaltungen sind ähnlich einem Instrumentierungsverstärker aufgebaut. Der Photostrom wird in einer Zwischenstufe als differentielle Spannung abgebildet, aber unmittelbar in ein auf ein Referenzpotential, bevorzugt Masse, bezogenes einpoliges (single-ended) Signal konvertiert.

Darüber hinaus sind Schaltungen bekannt, welche zwar eine vollkommen differentielle Signalaufbereitung durchführen, jedoch nur Wechselsignale verstärken - sie filtern den Gleichanteil mit Kondensatoren im Signalpfad. Beispielhaft sei hier das US-Patent 5343160 genannt. Aus elektronischer Sicht weist die dort offenbarte Schaltung jedoch eine Reihe von Nachteilen auf. Es sind potentialfreie Spannungsquellen vorhanden, der Dynamikbereich ist eingeschränkt, was vor allem bei niedrigen Versorgungsspannungen zu Problemen führen kann, zudem ist der Gleichspannungsarbeitspunkt unklar. Die symmetrische Ausgestaltung der Spannungsquellen ist zudem weder notwendig noch vorteilhaft, die beiden Quellen können problemlos zu einer einzigen zusammengefasst werden. Bei der konkreten Anwendung stellt der Gleichanteil (DC) des Messsignals eine wesentliche Größe dar, weshalb eine AC-Kopplung im Verstärker ungeeignet ist.

Bei einer weiteren, aus der US2001/0050333 A1 bekannten Schaltung handelt es sich um einen photoelektrischen Empfangsschaltkreis, der dafür geeignet ist, hochfrequente optische Signale in elektrische Spannungssignale umzusetzen. Dazu wird das Signal der Photodiode zunächst zwar DC-gekoppelt in eine differentielle Spannung umgewandelt, danach wird jedoch der Gleichanteil über Kondensatoren entfernt. Zur Weiterverarbeitung muss das Signal über einen weiteren Differenzverstärker aufbereitet werden. Dabei hängen die unteren Grenzfrequenzen von positivem und negativem Signalpfad nicht nur von den eingesetzten Kondensatoren sondern auch vom Eingangswiderstand des Verstärkers ab. Schaltungen dieser Art eignen sich gut zur Datenübertragung mit großer Datenrate, sind aber aufgrund der AC-Kopplung zur kontinuierlichen Erfassung geringster Lichtmengen ungeeignet.

Daher wird die Aufgabe der hochgenauen Verstärkung gemäß der vorliegenden Erfindung bei einer Schaltungsanordnung der eingangs genannten Art dadurch gelöst, dass zur direkten Umwandlung des Photostroms in eine differentielle Spannung ein Transimpedanz-Verstärker mit durchgehender DC-Kopplung zwischen Detektor und ADC verwendet wird, welcher zwei symmetrisch aufgebaute und differentiell angesteuerte Transimpedanz-Verstärkerzweige aufweist, die jeweils zwischen einem der Stromausgänge des Detektors und einem der Spannungseingänge des ADC vorgesehen sind. Die erfindungsgemäße Schaltungsanordnung bietet eine differentielle Strom-Zu-Spannung-Konversion unter Verwendung der minimal notwendigen hochgenauen Referenzbauteile bei gleichzeitiger optimaler Ausnutzung des Dynamikbereichs. Die Signalaufbereitung erfolgt vollständig differentiell, eine single-endedto-differentiat-Konversion mit ihren möglichen Nachteilen ist nicht erforderlich. Aus dem Photostrom wird direkt ein differentielles Spannungssignal erzeugt, das keinen Bezug zum eventuell störungsbehafteten Massepotential besitzt. Die für die Strom-Zu-Spannung-Konversion notwendige Transimpedanz wird je zur Hälfte auf die beiden Verstärkerzweige aufgeteilt. Ein weiterer Vorteil ist dabei der Betrieb der Photodiode ohne Vorspannung, wodurch Sensitivität, Stabilität und Genauigkeit gegenüber Schaltungsanordnungen mit unter Vorspannung betriebener Photodiode deutlich verbessert werden. Zudem werden durch die DC-Kopplung die Probleme von Hochpässen und deren Paarung im Frequenzgangvermieden.

In bevorzugter Ausgestaltung der Erfindung ist in den beiden Verstärkerzweigen jeweils ein mit einem Signaleingang mit jeweils einem Stromausgang des Detektors verbundener Operationsverstärker vorgesehen, wobei dieser Signaleingang weiters über ein Rückkopplungsnetzwerk mit zumindest einem Referenzwiderstand mit dem Ausgang des Operationsverstärkers rückgekoppelt und der andere Eingang des Operationsverstärkers mit einer Referenzspannungsquelle verbunden ist. Störungen auf der Referenzspannung treten damit nur als Gleichtakt-Störung auf und haben bei der hohen Gleichtaktunterdrückung (common mode rejection ratio, CMRR) des ADC keinen Einfluss auf die Signalqualität. Die Referenzwiderstände in beiden Verstärkerzweigen besitzen denselben Wert, der den Grad der Verstärkung bestimmt - je höher der Wert, desto größer die aus dem Photostrom resultierende Spannung.

Die Referenzspannung kann über zwei gleich große Widerstände geteilt und für die symmetrische Aussteuerung der Eingänge des nachfolgenden ADC um die halbe Referenzspannung verwendet werden. Diese Widerstände zum Aufteilen der Referenzspannung sollten groß genug gewählt werden, um die Referenzspannungsquelle nicht allzu sehr zu belasten, aber niedrig genug, damit der Mittelpunkt nicht hochohmig und damit störungsanfälligwird. Der Absolutwert der Mittelspannung fällt bei der Differenzbildung am ADC heraus und spielt daher für die Genauigkeit der Schaltungsanordnung keine Rolle.

Das Rückkopplungsnetzwerk jedes der beiden Operationsverstärker kann in weiters bevorzugter Ausgestaltung der Erfindung zumindest einen parallel zum Referenzwiderstand geschalteten Kondensator aufweisen, was zur Korrektur des Phasenganges dient. Ohne diese Kondensatoren könnte die Schaltungsanordnung aufgrund der internen Kapazität der Photodiode zu schwingen beginnen. Zur Unterdrückung dieses Verhaltens können die entsprechenden Kapazitätswerte aus den Kapazitätswerten der Photodiode und denen der Eingänge der Operationsverstärker errechnet werden.

In weiterer Ausgestaltung der Erfindung können die mit dem Detektor verbundenen Signaleingänge der Operationsverstärker zur Vorgabe eines Offsetstromes mit einer Konstantstromquelle verbunden sein. Hintergrund dieser Ausgestaltung ist, dass das über die Photodiode bzw. den Photodetektor nachzuweisende Licht nur eine unidirektionale Aussteuerung hervorrufen kann, wodurch lediglich der halbe differentielle Aussteuerbereich ausgenutzt wird. Durch die Vorgabe eines Offsetstroms kann der Aussteuerbereich einfach vergrößert werden.

Zur Darstellung der Konstantstromquelle können die mit dem Detektor verbundenen Signaleingänge der Operationsverstärker über je einen Widerstand, der vorzugsweise zumindest annähernd gleich ist wie der Referenzwiderstand in der Rückkoppelung, mit der Referenzspannungsquelle einerseits und Masse andererseits verbunden sein. Wenn bei dieser einfachen Bereitstellung des Offsetstroms die Widerstände gleich wie der Referenzwiderstand in der jeweiligen Rückkoppelung gewählt werden, kann der vollständige Aussteuerbereich genutzt werden.

Die Erfindung wird im Folgenden anhand der in den beiden Figuren schematisch dargestellten Beispiele für entsprechende Schaltungsanordnungen näher erläutert.

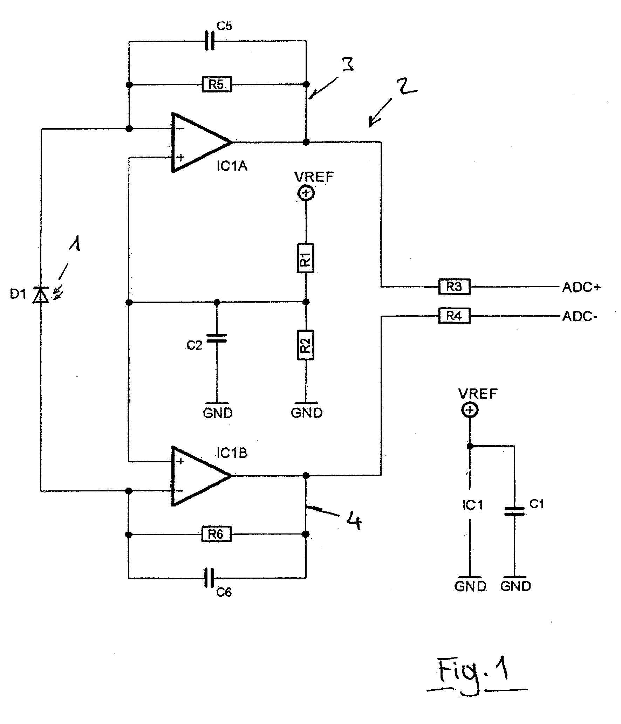

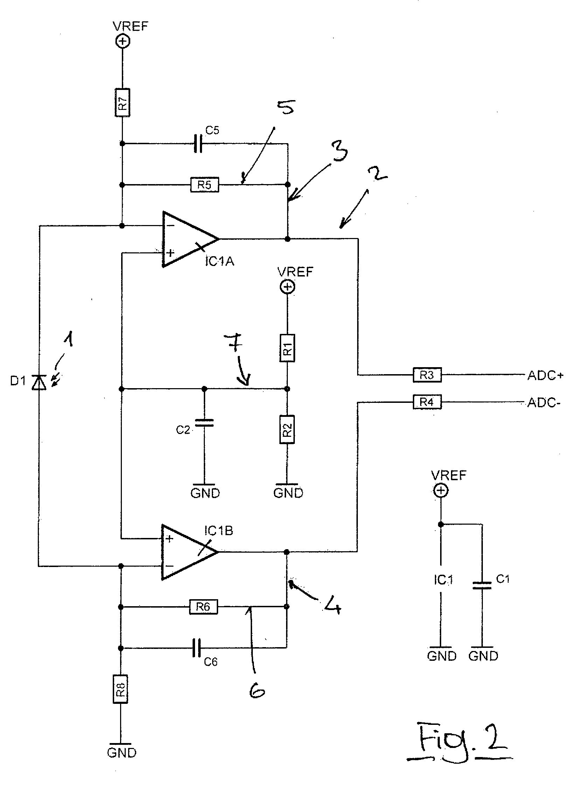

Der grundsätzliche Aufbau der Schaltungsanordnungen gemäß Fig. 1 und Fig. 2 ist gleich und wird auch gemeinsam beschrieben - das Ausführungsbeispiel nach Fig. 2 unterscheidet sich lediglich dadurch, dass hier zur Vorgabe eines Offsetstroms die mit dem Detektor verbundenen Signaleingänge der Operationsverstärker der beiden Transimpedanz-Verstärkerzweige mit einer Konstantstromquelle verbunden sind.

Die in beiden Fällen dargestellte Schaltanordnung dient beispielsweise zur Streulichtmessung von Partikeln im Abgas von Brennkraftmaschinen und weist einen basierend auf dem zu messenden Licht (Pfeile 1) einen analogen Photostrom liefernden Detektor D1, einen eingansseitig damit verbundenen Transimpedanz-Verstärker 2 sowie einen hier nicht weiter dargestellten mit dem Ausgang des Transimpedanz-Verstärkers 2 verbundenen ADC mit differentieller Eingangsstufe (ADC+, ADC-) auf, dessen Ausgang dann ein dem zum messenden Licht 1 proportionales Digitalsignal für eine ebenfalls nicht weiter dargestellte, angeschlossene digitale Auswerteeinheit bereitstellt. Der Transimpedanz-Verstärker 2 weist zur direkten Umwandlung des Photostroms in eine differentielle Spannung zwei völlig symmetrisch aufgebaute und differentiell angesteuerte Transimpedanz-Verstärkerzweige 3, 4 auf, die jeweils zwischen einem der Stromausgänge des Detektors D1 und einem der Spannungseingänge (ADC+, ADC-) des ADC vorgesehen sind. In den beiden Verstärkerzweigen 3, 4 ist jeweils ein mit einem Signaleingang (-) mit jeweils einem Stromausgang des Detektors D1 verbundener Operationsverstärker (IC1A, IC1B) vorgesehen, wobei eben dieser Signaleingang (-) weiters über ein Rückkopplungsnetzwerk 5, 6 mit zumindest einem Referenzwiderstand (R5, R6) mit dem Ausgang des Operationsverstärkers (IC1A, IC1B) rückgekoppelt ist. Der andere Eingang (+) des Operationsverstärkers (IC1A, IC1B) ist jeweils mit einer Referenzspannungsquelle 7 verbunden.

Die Referenzspannungsquelle 7 weist hier zwei Widerstände R1, R2 auf, die gleich groß sind und die überVREF und Masse (GND) anliegende Referenzspannung in der Hälfte teilen. Der Kondensator C2 dient lediglich zur Glättung und Entfernung allfälliger Störungen. Der nachfolgende ADC benötigt eine differentielle Aussteuerung um die halbe Referenzspannung, wobei einige Prozent Abweichung toleriert werden. Der Absolutwert der Mittelspannung fällt bei der Differenzbildung am ADC heraus und spielt daher für die Genauigkeit keine Rolle. Aus diesem Grund kann die als Mittelspannung zugeführte Referenzspannung auf einfache Weise über einen Spannungsteiler realisiert werden.

Die beiden jeweils rechts unten dargestellten Teile der Schaltungsanordnung zeigen lediglich die Spannungsversorgung der beiden Operationsverstärker IC1A, IC1B ebenfalls über die Referenzspannung.

Wie aus beiden Figuren ersichtlich ist, ist der gesamte Signalpfad vom optischen Detektor D1 bis zum ADC symmetrisch aufgebaut und differentiell ausgesteuert. Es handelt sich um eine vollständig differentielle Signalaufbereitung, welche keine zwischenzeitige single-ended-to-differential-Konversion beinhaltet. Aus dem Photostrom wird direkt ein differentielles Spannungssignal erzeugt, das keinen Bezug zum eventuell störungsbehafteten Massepotential besitzt. Störungen auf der Referenzspannung können nur als Gleichtakt-Störung auftreten und haben wegen der hohen Gleichtaktunterdrückung des ADC keinen Einfluss auf die Signalqualität. Ein weiterer Vorteil ist der hier gegebene Betrieb der Photodiode ohne Vorspannung, wodurch Sensitivität, Stabilität und Genauigkeit gegenüber einer Schaltung mit Vorspannung deutlich verbessert werden können.

Die beiden verwendeten Operationsverstärker IC1A, IC1B können vorteilhafterweise auch in monolithischer Form gemeinsam als integrierte Schaltung aufgebaut werden, was vorteilhafte Paarungseigenschaften ergibt.

Bei der Schaltungsanordnung nach Fig. 2 ist wie erwähnt ein Offsetstrom vorgegeben, der den Aussteuerungsbereich vergrößert. Hintergrund dazu ist, dass das Licht 1 an D1 nur eine unidirektionale Aussteuerung hervorrufen kann, wodurch lediglich der halbe differentielle Aussteuerungsbereich ausgenutzt wird. Durch Vorgabe eines Offsetstroms kann der Aussteuerungsbereich vergrößert werden, wobei der vollständige Aussteuerungsbereich dann zur Verfügung steht, wenn die Referenzwiderstände R5 und R6 in der Rückkoppelung der Operationsverstärker IC1A, IC1B, gleich wie die Widerstände R7 und R8 der hier wiederum anliegenden ReferenzspannungVREFsind.

## Patentansprüche

1. Schaltungsanordnung zur Auswertung photoelektrischer Messungen, insbesonders zur Streulichtmessung von Partikeln im Abgas von Brennkraftmaschinen, mit einem basierend auf dem zu messenden Licht (1)einen analogen Photostrom liefernden Detektor (D1), einem eingangsseitig damit verbundenen Transimpedanz-Verstärker (2), sowie einem mit dem Ausgang des Transimpedanz-Verstärkers (2) verbundenen Analog-/Digitalwandler (ADC) mit differentieller Eingangsstufe, dessen Ausgang ein dem zu messenden Licht (1) proportionales Digitalsignal für eine angeschlossene digitale Auswerteeinheit bereitstellt, **dadurch gekenntzeichnet,** dass zur direkten Umwandlung des Photostroms in eine differentielle Spannung ein Transimpedanz-Verstärker (2) mit durchgehender DC-Kopplung zwischen Detektor (D1) und ADC verwendet wird, welcher zwei symmetrisch aufgebaute und differentiell angesteuerte Transimpedanz-Verstärl<erzweige (3, 4) aufweist, die jeweils zwischen einem der Stromausgänge des Detektors (D1) und einem der Spannungseingänge (ADC+, ADC-) des ADC vorgesehen sind.

2. Schaltungsanordnung nach Anspruch 1, **dadurch gekennzeichnet, dass** in den beiden Verstärkerzweigen (3, 4) jeweils ein mit einem Signaleingang (-) mit jeweils einem Stromausgang des Detektors (D1) verbundener Operationsverstärker (IC1A, IC1 B) vorgesehen ist, dass dieser Signaleingang (-) weiters über ein Rückkopplungsnetzwerk (5, 6) mit zumindest einem Referenzwiderstand (R5, R6) mit dem Ausgang des Operationsverstärkers (IC1A, IC1B) rückgekoppelt ist, und dass der andere Eingang (+) des Operationsverstärkers (IC1A, IC1B) mit einer Referenzspannungsquelle (7) verbunden ist.

3. Schaltungsanordnung nach Anspruch 2 , **dadurch gekennzeichnet, dass** das Rückkopplungsnetzwerk (5, 6) zumindest einen parallel zum Referenzwiderstand geschalteten Kondensator (C5, C6) aufweist.

4. Schaltungsanordnung nach einem der Ansprüche 1 bis 3, **dadurch gekennzeichnet, dass** zur Vorgabe eines Offsetstromes die mit dem Detektor (D1) verbundenen Signaleingänge (-) der Operationsverstärker (IC1A, IC1B) mit einer Konstantstromquelle verbunden sind.

5. Schaltungsanordnung nach Anspruch 4, **dadurch gekennzeichnet, dass** zur Darstellung der Konstantstromquelle die mit dem Detektor (D1) verbundenen Signaleingänge(-) der Operationsverstärker (IC1A, IC1B) über je einen Widerstand (R7, R8), dervorzugsweise zumindest annähernd gleich ist wie der Referenzwiderstand (R5, R6) in der Rückkoppelung, mit der Referenzspannungsquelle (VREF, 7) einerseits und Masse (GND) andererseits verbunden sind.

## Claims

1. Circuit arrangement for evaluating photoelectric measurements, in particular for the scattered light measurement of particles in the exhaust of combustion engines, with an analog photocurrent detector (D1) based on the light (1) to be measured, a transimpedance amplifier (2) connected to it on the input side, as well as an analog/digital converter (ADC), connected to the output of the trans-impedance amplifier (2), with a differential input stage, whose output provides a digital signal proportional to the light (1) to be measured for a connected digital evaluation unit, **characterized in that** for the direct conversion of the photocurrent into a differential voltage, a transimpedance amplifier (2) with a continuous DC coupling between the detector (D1) and the ADC is used, which has two symmetrically constructed and differentially actuated transimpedance amplifier branches (3, 4), which are each provided between a current output of the detector (D1) and one of the voltage inputs (ADC+, ADC-) of the ADC.

2. Circuit arrangement according to claim 1, **characterized in that** in each of the two amplifier branches (3, 4), an operational amplifier (IC1A, IC1B) is provided connected to a signal input (-) with respectively one current output of the detector (D1), **in that** this signal input (-) is also fed back via a feedback network (5, 6) with at least one reference resistance (R5, R6) to the output of the operations amplifier (IC1A, IC1B), and **in that** the other input (+) of the operations amplifier (IC1A, IC1B) is connected to a reference voltage source (7).

3. Circuit arrangement according to claim 2, **characterized in that** the feedback network (5, 6) has at least one capacitor (C5, C6) switched in parallel to the reference resistance.

4. Circuit arrangement according to one of the claims 1 to 3, **characterized in that** to specify an offset current, the signal inputs (-),connected to the detector (D1), of the operational amplifier (IC1A, IC1B) are connected to a constant current source.

5. Circuit arrangement according to claim 4, **characterized in that** to represent the constant current source, the signal inputs (-), connected to the detector (D1), of the operational amplifiers (IC1A, IC1B) via one resistance (R7, R8) each, which is preferably at least approximately equal to the reference resistance (R5, R6) in the feedback , are connected to the reference voltage source (VREF, 7) on the one hand and to the ground (GND) on the other.

## Revendications

1. Circuit pour l'exécution de mesures photoélectriques, en particulier pour la mesure de la lumière diffuse de particules contenues dans le gaz échappement de moteurs à combustion interne, comportant un détecteur (D1) qui livre un courant photoélectrique analogique sur la base de la lumière à mesurer (1), un amplificateur à transimpédance (2) connecté à ce détecteur côté entrée ainsi qu'un convertisseur analogique/numérique (ADC) connecté à la sortie de l'amplificateur à transimpédance (2), comportant un étage d'entrée différentiel, dont la sortie fournit un signal numérique proportionnel à la lumière à mesurer (1) à une unité d'évaluation numérique connectée, **caractérisé en ce que**, pour la transformation directe du courant photoélectrique en une tension différentielle, est utilisé un amplificateur à transimpédance (2) comportant un couplage en courant continu direct entre le détecteur (D1) et le ADC, qui présente deux branches d'amplificateur à transimpédance (3, 4) de construction symétrique et à commande différentielle, qui sont intercalées chacune entre l'une des sorties de courant du détecteur (D1) et l'une des entrées de tension (ADC+, ADC-) de l'ADC.

2. Circuit selon la revendication 1, **caractérisé en ce que**, dans chacune des deux branches d'amplificateur (3, 4) est utilisé un amplificateur opérationnel (IC1A, IC1B) connecté par une entrée de signal (-) à une sortie de courant du détecteur (D1), **en ce que** cette entrée de signal (-) est par ailleurs rétrocouplée par l'intermédiaire d'un réseau de rétrocouplage (5, 6) comportant au moins une résistance de référence (R5, R6) à la sortie de l'amplificateur opérationnel (IC1A, IC1B) et **en ce que** l'autre entrée (+) de l'amplificateur opérationnel (IC1A, IC1B) est connectée à une source de tension de référence (7).

3. Circuit selon la revendication 2, **caractérisé en ce que** le réseau de rétro-couplage (5, 6) présente au moins un condensateur (C5, C6) connecté en parallèle à la résistance de référence.

4. Circuit selon l'une des revendications 1 à 3, **caractérisé en ce que**, pour la prédéfinition d'un courant de décalage, les entrées de signal (-) des amplificateurs opérationnels (IC1A, IC1b connectées au détecteur (D1) sont connectées à une source de tension constante.

5. Circuit selon la revendication 4, **caractérisé en ce que**, pour représenter la source de tension constante, les entrées de signal (-) des amplificateurs opérationnels (IC1A, IC1B) qui sont connectées au détecteur (D1) sont connectées chacune à travers une résistance (R7, R8) qui est de préférence au moins approximativement égale à la résistance de référence (R5, R6) dans le rétrocouplage, à la source de tension de référence (VREF, 7), d'une part, et à la masse (GND), d'autre part.
